# FASCICULE DE BREVET EUROPEEN

(11) **EP 0 964 741 B1**
(45) Date de publication et mention de la délivrance du brevet: **03.09.2003**
(21) Numéro de dépôt: 98912350.0
(22) Date de dépôt: 20.02.1998
(51) Int. Cl.: B01J 3/00, C23C 28/02, H01J 7/18, C23C 14/56

(54) **PROCEDE POUR AMELIORER LE VIDE DANS UN SYSTEME A VIDE TRES POUSSE**
VERFAHREN ZUR VERBESSERUNG EINES VAKUUMS IN EINEM HOCHVAKUUMSYSTEM
METHOD FOR IMPROVING VACUUM IN A VERY HIGH VACUUM SYSTEM

(30) Priorité: 26.02.1997 FR 9702305
(43) Date de publication de la demande: 22.12.1999
(73) Titulaire: ORGANISATION EUROPEENNE POUR LA RECHERCHE NUCLEAIRE (CERN), 1211 Geneve 23 (CH)
(72) Inventeur: BENVENUTI, Cristoforo, F-01280 Moens (FR)
(74) Mandataire: Gorrée, Jean-Michel
(86) Numéro de dépôt international: EP9800978
(87) Numéro de publication internationale: WO98037958

(56) Documents cités:
- US-A- 3 630 690
- US-A- 4 000 335
- PATENT ABSTRACTS OF JAPAN vol. 016, no. 043 (C-0907), 4 février 1992 & JP 03 247778 A (ULVAC JAPAN LTD), 5 novembre 1991,
- PATENT ABSTRACTS OF JAPAN vol. 013, no. 579 (C-668), 20 décembre 1989 & JP 01 242134 A (HITACHI LTD), 27 septembre 1989,

## Description

La présente invention concerne des perfectionnements apportés en vue d'améliorer le vide dans un système à vide très poussé (ultravide) comprenant une enceinte susceptible de relâcher du gaz à sa surface. Plus spécifiquement, l'invention vise des perfectionnements apportés au procédé mentionné dans le préambule de la revendication 1.

Dans un système métallique étuvable dans lequel doit être réalisé un vide très poussé (c'est-à-dire un vide d'au moins 10⁻¹⁰ Torr, voire d'un ordre de grandeur de 10⁻¹³ à 10⁻¹⁴ Torr) (1 Torr = 133,32 Pa), les parois métalliques de l'enceinte à vide constituent une source inépuisable de gaz. L'hydrogène contenu dans le métal de construction (par exemple acier inoxydable, cuivre, alliage d'aluminium) diffuse librement dans l'épaisseur du métal et est relâché à la surface définissant l'enceinte. De même, lorsque les parois de la chambre à vide sont bombardées par des particules (rayonnement de synchroton, électrons ou ions) -comme c'est la cas dans les accélérateurs de particules-, il en résulte l'expulsion aussi d'espèces moléculaires plus lourdes, telles que CO, CO₂, CH₄, produites en surface après dissociation d'hydrocarbures,. carbures et oxydes.

Le niveau de vide obtenu dans l'enceinte est donc défini par l'équilibre dynamique entre le dégazage à la surface définissant l'enceinte et la vitesse de pompage des pompes utilisées. L'obtention d'un vide élevé implique à la fois une grande propreté de la surface de l'enceinte réduisant l'émission de gaz et une vitesse de pompage élevée. Pour les systèmes à vide des accélérateurs de particules dont les chambres sont généralement de petite section, les pompes doivent être rapprochées les unes des autres ou bien il faut mettre en oeuvre un pompage continu, afin de surmonter la limitation de conductance.

Dans ces conditions, pour parvenir à obtenir un vide aussi poussé que possible, il est connu de compléter le vide produit par des pompes mécaniques en effectuant un pompage complémentaire, notamment à l'aide d'un getter disposé dans l'enceinte : ce matériau est capable de produire des composés chimiquement stables par réaction avec les gaz présents dans une enceinte à vide (notamment H₂, O₂, CO, CO₂, N₂) et cette réaction donne lieu à la disparition des espèces moléculaires concernées, ce qui correspond à un effet de pompage.

Toutefois, quel que soit le processus de pompage mis en oeuvre, et malgré l'efficacité du pompage réparti que permet d'effectuer la mise en oeuvre d'un getter non évaporable, le niveau de vide susceptible d'être obtenu dans l'enceinte reste défini par l'équilibre dynamique entre la vitesse de pompage (quels que soient les moyens mis en oeuvre) et le taux de dégazage de la surface métallique de l'enceinte (quelle qu'en soit la cause) ; autrement dit pour une vitesse de pompage donnée, le niveau de vide reste tributaire du taux de dégazage dans l'enceinte.

Pour améliorer la qualité de l'ultravide dans l'enceinte, il s'avère donc souhaitable de tenter de réduire sensiblement le taux de dégazage à la surface de la paroi métallique de l'enceinte, et par là même d'accroître sensiblement l'efficacité des moyens de pompage.

L'invention a donc pour but de proposer une solution perfectionnée qui permette de résoudre ces problèmes et qui réduise le taux de dégazage se produisant dans l'enceinte et accroisse notablement l'efficacité des moyens de pompage mis en oeuvre, en permettant d'aboutir, de façon plus économique, à des vides très poussés ou ultravides (par exemple de l'ordre de 10⁻¹⁰ à 10⁻¹³ Torr).

A ces fins, il est proposé conformément à l'invention un procédé tel que défini au préambule de la revendication 1 qui se caractérise par les succession des étapes énoncées dans la partie caractérisante de la revendication 1.

Grâce à la mise en oeuvre d'un tel procédé, on bénéficie d'un avantage essentiel, dans le cadre de la présente invention, des corps catalyseurs utilisables qui réside dans leur faible oxydation : lorsque ces catalyseurs sont exposés à l'air, ils ne réagissent que très faiblement avec l'oxygène à leur surface et il n'est donc plus besoin de procéder à une étape d'activation par chauffage en vue d'éliminer la couche de passivation.

Il en résulte également un autre avantage résidant dans la durée de vie en principe illimitée de la couche de catalyseur, puisque l'absorption de gaz est thermiquement réversible.

Cette couche de catalyseur constitue un écran qui inhibe le dégazage du métal de la paroi de l'enceinte, sans en produire à son tour. En outre, dans les chambres des accélérateurs de particules, c'est cette couche qui subit les impacts des particules ou du rayonnement de synchrotron et qui, formant écran, empêche la libération d'espèces moléculaires susceptible de polluer le vide dans l'enceinte. Il en résulte que, par ce moyen, on empêche, au moins dans une grande mesure, le dégazage, quelle qu'en soit la cause, dans l'enceinte.

Enfin, un catalyseur tel que précité est apte à procurer un effet de pompage de surface d'espèces moléculaires présentes dans l'enceinte.

On a trouvé que les résultats les plus intéressants étaient obtenus avec des alliages de palladium, et plus particulièrement avec l'alliage palladium-argent.

Le dépôt de la couche de catalyseur sur la surface de la paroi métallique de l'enceinte, bien que pouvant s'effectuer par tout moyen approprié connu de l'Homme de Métier et efficace dans le contexte technique considéré, est, dans le cadre de l'invention, effectué par pulvérisation cathodique, comme cela sera expliqué plus loin.

Il faut toutefois noter que le catalyseur présente un aspect défavorable qui réside dans le fait que, contrairement à un getter non évaporable, le catalyseur ne procure qu'un effet de pompage sélectif : autrement dit, il est capable de pomper certaines espèces moléculaires : H₂ et CO, mais pas toujours d'autres espèces moléculaires : N₂ et CO₂. Toutefois, cette sélectivité peut, dans certaines applications plus particulièrement envisagées (chambres à vide d'accélérateur de particules), ne pas se révéler rédibitoire du fait que les espèces moléculaires H₂ et CO sont majoritaires.

Il faut en outre noter, au surplus, que les catalyseurs présentent un effet de pompage de l'espèce H₂ qui certes existe, mais reste limité sous basse pression. Toutefois, un abaissement de la température permet d'améliorer la quantité de H₂ pompée : de l'ordre d'une fraction seulement de couche moléculaire à la température ambiante d'environ 20°C, cette quantité croît à plus basse température. Par exemple, avec le palladium qui constitue un catalyseur actuellement préféré en raison des résultats procurés, la pression d'équilibre pour une monocouche d'hydrogène adsorbée en surface est de 10⁻⁷ Torr à la température ambiante, mais elle devient complètement négligeable à la température d'ébullition de l'azote liquide (77°K).

C'est pour remédier à l'insuffisance de la capacité de pompage du catalyseur vis-à-vis de certaines espèces moléculaires, telles que H₂ et ses isotopes, que l'on prévoit la mise en place d'une sous-couche de matériau getter non évaporable appliquée directement sur la paroi de l'enceinte. La ou les espèces moléculaires précitées, telles que l'hydrogène et ses isotopes, sont ainsi transférées de la surface exposée au vide, à travers la couche de catalyseur, jusqu'à la couche de getter non évaporable soit à la température ambiante sur un temps long, soit de façon accélérée sur un temps plus court, voire très court, en mettant en oeuvre un chauffage à une température d'environ 50 à 70°C. Ainsi, alors qu'à la température ambiante d'environ 20°C une couche de palladium saturée par H₂ permet d'atteindre un vide de 10⁻⁷ Torr seulement, en chauffant à 70°C le même catalyseur peut conduire à un vide de 10⁻¹³ Torr.

Pour ce qui est de la couche de getter non évaporable, du choix du ou des matériaux constitutifs et de son procédé de réalisation, on pourra avoir recours à toute solution connue de l'Homme de Métier et propre à donner satisfaction dans le cadre de la présente invention. Toutefois, de préférence et de façon très avantageuse, on pourra avoir recours aux dispositions exposées dans le document FR-A-2 750 248 (WO-A-9 749 109) au nom de la Demanderesse.

On rappellera seulement que le matériau NEG doit en particulier posséder un grand pouvoir d'absorption et une grande diffusivité pour l'hydrogène, avec si possible capacité à former une phase hydrure ; il doit, en outre, présenter une pression de dissociation de la phase hydrure inférieure à 10⁻¹³ Torr à environ 20°C. Le matériau doit également posséder une température d'activation aussi basse que possible, compatible avec les températures d'étuvage des systèmes à vide (environ 400°C pour les chambres en acier inoxydable, 200 - 250°C pour les chambres en cuivre et alliage d'aluminium) et compatible avec la stabilité du matériau à l'air, à environ 20°C ; dans ces conditions, d'une façon générale la température d'activation doit être au plus égale à 400°C, mais pas inférieure à 150°C.

En définitive, le titane, le zirconium, le hafnium, le vanadium et le scandium qui présentent une limite de solubilité pour l'oxygène, à la température ambiante, supérieure à 2 % constituent des getter non évaporables appropriés pour constituer un revêtement en couche mince dans le cadre de l'invention. On peut, bien entendu, retenir également tout alliage ou composé de ces corps entre eux, ou tout alliage ou composé d'un ou plusieurs de ces corps avec d'autres, de manière à combiner les effets obtenus, voire à obtenir des effets nouveaux ne résultant pas directement du cumul des effets individuels.

La mise en oeuvre d'une structure multicouche conformément à l'invention s'effectue de façon simple ;
- on dépose au moins une couche mince de getter non évaporable sur au moins la quasi totalité de la surface de la paroi de l'enceinte ;
- on effectue ensuite un dépôt d'au moins une couche mince d'au moins un catalyseur sur ladite couche de getter, ledit catalyseur étant choisi parmi le ruthénium et/ou le rhodium et/ou le palladium et/ou l'osmium et/ou l'iridium et/ou le platine et/ou un alliage contenant au moins l'un de ceux-ci;
- on assemble l'enceinte avec un système à vide ; et
- on fait le vide à l'aide du système de pompage.

Pour le dépôt par double pulvérisation cathodique, le dépôt de la couche NEG énoncée dans la première étape ci-desus est réalisée à l'aide d'au moins une première électrode appropriée pour la pulvérisation cathodique du getter comme indiqué dans le document FR-A-2 750 248. Puis, le dépôt achevé, cette première électrode est enlevée hors de l'enceinte et remplacée, avant d'aborder la seconde étape ci-dessus, par au moins une seconde électrode appropriée pour la pulvérisation cathodique du catalyseur. En raison de l'exposition de la couche de getter à l'atmosphère ambiante entraînée par cette substitution d'électrode, il est nécessaire de pomper, puis d'activer thermiquement la couche de getter avant d'effectuer le dépôt de la couche de catalyseur par pulvérisation cathodique.

Un exemple de mise en oeuvre pratique de ce procédé peut comprendre les étapes qui suivent :
- on nettoie l'enceinte ; on introduit un dispositif de dépôt de getter en couche mince à l'intérieur de l'enceinte; on crée un vide relatif dans l'enceinte ; on effectue un étuvage de l'enceinte afin d'évacuer la plus grande partie possible de la vapeur d'eau ; puis on effectue le dépôt du getter en une couche mince sur au moins la plus grande partie de la surface de la paroi définissant l'enceinte ;
- on rétablit la pression atmosphérique dans l'enceinte ; et on extrait le dispositif de dépôt du getter hors de l'enceinte et on introduit un dispositif de dépôt de catalyseur à l'intérieur de l'enceinte ;
- on crée un vide relatif dans l'enceinte ; on réalise un étuvage de l'installation à la température voulue tout en maintenant l'enceinte à une température inférieure à la température d'activation du getter ;
- on arrête l'étuvage de l'installation et simultanément on élève la température de l'enceinte jusqu'à la température d'activation du getter que l'on maintient pendant une durée prédéterminée (par exemple 1 à 2 heures) ; et enfin on ramène la température de l'enceinte à la température ambiante ; à la fin de cette procédure, la surface de la couche mince de getter est propre et son dégazage thermique est fortement réduit ;
- enfin on dépose au moins une couche de catalyseur sur la couche NEG.

Pour éviter les sujetions entraînées par le changement des électrodes (exposition de la couche de getter à l'atmosphère ambiante), on peut envisager de mettre en place, dès le départ, une électrode double comportant simultanément les deux matériaux NEG et catalyseur et excitable de façon séquentielle de sorte que le getter, puis le catalyseur peuvent être déposés successivement sans traitement intermédiaire du getter ; pour obtenir des dépôts homogènes sur toute la paroi de l'enceinte, une telle électrode peut être tournante.

Après la mise en place dans le système à vide définitif, la surface de la couche de catalyseur est en principe recouverte de quelques monocouches de vapeur d'eau qui doivent être éliminées par pompage. L'élimination est plus rapide si le pompage est accompagné d'un étuvage du système à vide, par chauffage à une température d'au moins 120°C et jusqu'à 300°C si possible.

Un catalyseur mis en oeuvre sous la forme d'une couche telle que précitée s'étend sur toute la longueur de l'enceinte et conserve donc l'avantage d'un pompage réparti de façon uniforme. De plus, une couche de catalyseur conforme à l'invention n'occupe aucun espace sensible et offre l'avantage de procurer un effet de pompage sous un encombrement nul, ce qui permet sa mise en oeuvre même dans des cas où les contraintes géométriques interdiraient l'emploi d'un matériau de pompage sous forme de ruban.

## Revendications

1. Procédé pour la mise en oeuvre d'un revêtement à fonction getter propre à créer, par action getter, un vide très poussé (ultravide) dans une enceinte définie par une paroi métallique susceptible de relâcher du gaz à sa surface, ledit revêtement à fonction getter étant disposé sur au moins la plus grande partie de la surface de la paroi de l'enceinte,
**caractérisé par** la succession des étapes qui suivent :
- on dépose, par pulvérisation cathodique, au moins une couche mince métallique de getter non évaporable sur au moins la plus grande partie de la surface de la paroi de l'enceinte, ledit getter étant propre à absorber l'hydrogène et ses isotopes et étant choisi parmi le titane et/ou le zirconium et/ou le hafnium et/ou le vanadium et/ou le scandium et/ou un alliage ou composé métallique comprenant au moins l'un de ceux-ci ;
- on dépose ensuite, par pulvérisation cathodique, au moins une couche mince d'au moins un catalyseur sur ladite couche de getter non évaporable, ledit catalyseur étant choisi parmi le ruthénium et/ou le rhodium et/ou le palladium et/ou l'osmium et/ou l'iridium et/ou le platine et/ou un alliage contenant au moins l'un de ceux-ci ;
- l'électrode utilisée pour la pulvérisation cathodique étant enlevée une fois terminé le dépôt de la couche ;
- on assemble l'enceinte à vide ; et
- on fait le vide à l'aide du système de pompage,
ce grâce à quoi ledit revêtement arrête les gaz relâchés par la paroi de l'enceinte, d'une part, et pompe l'hydrogène et ses isotopes présents dans l'enceinte lors de la mise sous vide, d'autre part.

2. Procédé selon la revendication 1, **caractérisé en ce que** le catalyseur est déposé sur la couche de getter non évaporable préalablement déposée sans exposition de cette dernière à l'atmosphère ambiante entre les deux dépôts.

3. Procédé selon la revendication 1, **caractérisé en ce que** la couche de getter non évaporable, exposée à l'atmosphère ambiante après son dépôt, est ensuite pompée et activée thermiquement avant le dépôt de la couche de catalyseur.

4. Procédé selon la revendication 1, **caractérisé en ce qu'**en même temps qu'on fait le vide à l'aide du système de pompage, on effectue un étuvage du système à vide par chauffage à une température d'au moins 120°C.

5. Procédé selon l'une quelconque des revendications 1 à 4, **caractérisé en ce que** le catalyseur est un alliage de palladium.

6. Procédé selon la revendication 5, **caractérisé en ce que** le catalyseur est un alliage palladium-argent.

## Patentansprüche

1. Verfahren zum Anwenden einer Beschichtung mit der Funktion eines geeigneten Fangstoffes zum Schaffen eines sehr hohen Vakuums (Ultravakuums) durch Getterwirkung in einem Behältnis, das durch eine metallische, zum Freisetzen von Gas an ihrer Oberfläche fähige Wand umgrenzt ist, wobei die Beschichtung mit Getterfunktion zumindest auf dem größten Teil der Oberfläche der Wand des Behältnisses angeordnet ist, **gekennzeichnet durch** die Abfolge der folgenden Schritte:
- **durch** Kathodenzerstäubung wird mindestens eine metallische Dünnschicht aus einem nicht verdampfbaren Getter auf zumindest dem größten Teil der Oberfläche der Wand des Behältnisses abgeschieden, wobei der besagte Getter dazu geeignet ist, Wasserstoff und dessen Isotope zu absorbieren und ausgewählt ist aus Titan und/oder Zirkon und/oder Hafnium und/oder Vanadium und/oder Skandium und/oder einer Legierung oder metallischen Zusammensetzung, die wenigstens einen dieser Stoffe enthält;
- dann wird **durch** Kathodenzerstäubung mindestens eine Dünnschicht mindestens eines Katalysators auf die besagte Schicht des nicht verdampfbaren Getters abgeschieden, wobei besagter Katalysator ausgewählt ist aus Ruthenium und/oder Rhodium und/oder Palladium und/oder Osmium und/oder Iridium und/oder Platin und/oder einer mindestens eines davon enthaltenden Legierung;
- die für die Kathodenzerstäubung verwendete Elektrode wird entfernt, sobald die Abscheidung der Schicht abgeschlossen ist;
- das Vakuumbehältnis wird zusammengebaut;
- das Vakuum wird mithilfe des Pumpsystems hergestellt, dank wessen besagte Beschichtung einerseits die von der Wand des Behältnisses freigesetzten Gase abfängt und andererseits den Wasserstoff und seine Isotope, die beim Evakuieren in dem Behältnis vorhanden sind, abpumpt.

2. Verfahren nach Anspruch 1, **dadurch gekennzeichnet, dass** der Katalysator auf der zuvor abgeschiedenen Schicht aus dem nicht verdampfbaren Getter abgeschieden wird, ohne dass diese letztere zwischen den beiden Abscheidungen der Umgebungsatmosphäre ausgesetzt wird.

3. Verfahren nach Anspruch 1, **dadurch gekennzeichnet, dass** die Schicht aus dem nicht verdampfbaren Getter, die nach ihrer Abscheidung der Umgebungsatmosphäre ausgesetzt wird, sodann abgepumpt und thermisch aktiviert wird, bevor die Katalysatorschicht abgeschieden wird.

4. Verfahren nach Anspruch 1, **dadurch gekennzeichnet, dass** gleichzeitig mit dem Herstellen des Vakuums mithilfe des Pumpsystems eine Trocknung des Vakuumsystems durch Aufheizen auf eine Temperatur von mindestens 120 °C bewirkt wird.

5. Verfahren nach einem der vorstehenden Ansprüche 1 bis 4, **dadurch gekennzeichnet, dass** der Katalysator eine Palladiumlegierung ist.

6. Verfahren nach Anspruch 5, **dadurch gekennzeichnet, dass** der Katalysator eine Palladium-Silber-Legierung ist.

## Claims

1. A method of applying a coating having a getter function adapted to generating, due to a getter effect, a very high (ultrahigh) vacuum in a chamber defined by a metal wall which possibly may release gas at its surface, said coating with a getter function being deposited on at least almost the whole surface of the chamber wall,
**characterized by** the succession of following steps:
- at least a thin metal layer of non-evaporable getter is deposited, by cathode sputtering, on at least almost the whole surface of the chamber wall, said getter being adapted to absorb hydrogen and isotopes thereof and being selected from titanium and/or zirconium and/or hafnium and/or vanadium and/or scandium and/or an alloy or metal composite including at least one of these;
- then at least a thin layer of at least a catalyst is deposited, by cathode sputtering, on said non-evaporable getter layer, said catalyst being selected from ruthenium and/or rhodium and/or palladium and/or osmium and/or iridium and/or platinum and/or an alloy including at least one of these;
- the electrode used for the cathode sputtering being removed after the end of the layer deposition;
- the vacuum chamber is assembled; and
- vacuum is generated with a pumping system;
whereby said coating stops gas released by the chamber wall, on one hand, and pumps hydrogen and isotopes thereof which are present in the chamber when vacuum is generated, on another hand.

2. The method according to Claim 1, **characterized in that** the catalyst is deposited on the non-evaporable getter layer which has been deposited beforehand without any exposure of this last to the ambient atmosphere between the two deposition steps.

3. The process according to Claim 1, **characterized in that** the non-evaporable getter layer, which has been exposed to the ambient atmosphere after having been deposited, is then pumped and thermally activated before depositing the layer of catalyst thereon.

4. The process according to Claim 1, **characterized in that**, at the same time the vacuum is generated with the pumping system, the vacuum system is dried by being heated to a temperature of at least 120°C.

5. The process according to anyone of Claims 1 to 4, **characterized in that** the catalyst is an alloy of palladium.

6. The process according to Claim 5, **characterized in that** the catalyst is a palladium-silver alloy.
